# FASCICULE DE BREVET EUROPEEN

(11) **EP 3 948 940 B1**
(45) Date de publication et mention de la délivrance du brevet: **07.06.2023**
(21) Numéro de dépôt: 20712990.9
(22) Date de dépôt: 25.03.2020
(51) Int. Cl.: H01L 21/02

(54) **PROCÉDÉ DE TRANSFERT DE PAVES D'UN SUBSTRAT DONNEUR SUR UN SUBSTRAT RECEVEUR**
VERFAHREN ZUR ÜBERTRAGUNG VON BLÖCKEN VON EINEM DONORSUBSTRAT AUF EIN EMPFÄNGERSUBSTRAT
METHOD FOR TRANSFERRING BLOCKS FROM A DONOR SUBSTRATE ONTO A RECEIVER SUBSTRATE

(30) Priorité: 29.03.2019 FR 1903350
(43) Date de publication de la demande: 09.02.2022
(73) Titulaire: SOITEC, 38190 Bernin (FR)
(72) Inventeur: LANDRU, Didier, 38190 LE CHAMP-PRES-FROGES (FR); GHYSELEN, Bruno, 38170 SEYSSINET-PARISET (FR)
(74) Mandataire: Regimbeau
(86) Numéro de dépôt international: PCT/EP2020/058427
(87) Numéro de publication internationale: WO 2020/200976

(56) Documents cités:
- US-A1- 2004 238 851
- US-A1- 2005 221 583
- US-A1- 2006 019 476
- US-A1- 2009 035 885
- WAYNE CHEN ET AL: "InP layer transfer with masked implantation", ELECTROCHEMICAL AND SOLID-STATE LETTERS, IEEE SERVICE CENTER, PISCATAWAY, NJ, US, vol. 12, no. 4, 1 avril 2009 (2009-04-01), pages H149-H150, XP002797029, ISSN: 1099-0062, DOI: 10.1149/1.3078487

## Description

### DOMAINE TECHNIQUE DE L'INVENTION

La présente invention concerne un procédé de transfert de pavés d'un premier substrat, dit « substrat donneur », sur un deuxième substrat, dit « substrat receveur ».

### ETAT DE LA TECHNIQUE

Dans le domaine des semi-conducteurs, la conception de structures semi-conductrices nécessite parfois de transférer des pavés se présentant sous forme de portions d'une couche mince destinée à la fabrication de composants électroniques, sur un substrat support ou substrat receveur.

Ce type de procédé est généralement désigné en tant que procédé de pavage, et met en jeu un transfert partiel d'une couche pour former un motif déterminé sur le substrat support. Autrement dit, on pave le substrat support avec des portions de ladite couche, qui est généralement une couche fine.

La couche fine peut être en un matériau cristallin massif (comme un semi-conducteur) voire une couche comportant une structure fonctionnelle (couche épitaxiale, dispositif passif, etc.). Un exemple courant d'applications est le pavage d'un substrat silicium pre-processé par des coupons de matériaux III-V configurés pour intégrer des dispositifs lasers sur des plateformes photoniques silicium.

Plusieurs techniques sont disponibles pour paver un substrat support.

Une première technique est l'épitaxie localisée, qui consiste à former localement la structure pavée par croissance épitaxiale sur le substrat support. Cela permet d'obtenir des couches minces voire des structures complexes.

La limitation principale de cette technique réside dans la qualité cristalline de la structure épitaxiée, qui est en effet relativement faible dans le cas où le matériau épitaxié présente un paramètre de maille différent de celui du substrat support. Une autre limitation concerne la température d'épitaxie relativement élevée, qui est susceptible d'endommager d'éventuels dispositifs électroniques déjà présents dans le substrat support.

Une seconde technique est le transfert d'une couche de pavage sur le substrat support suivi d'une gravure localisée de la couche de pavage. Le transfert peut se faire conformément au procédé Smart Cut^{™} par implantation d'ions dans la couche de pavage pour former une zone de fragilisation suivi d'un détachement d'une portion de la couche de pavage, ou bien par collage suivi d'un amincissement de la couche de pavage depuis la face opposée à l'interface de collage.

Cette technique présente deux inconvénients principaux : d'une part, le substrat donneur doit avoir la même taille que le substrat support, et d'autre part, cette technique nécessite de sacrifier une quantité importante du substrat donneur, ce qui est problématique dans le cas où celui-ci a une forte valeur, par exemple lorsqu'il est fabriqué dans un matériau semi-conducteur III-V tel que les nitrures III (par exemple, le nitrure d'indium gallium (InGaN)), les arséniures III (par exemple, l'arséniure d'indium gallium (InGaAs)) et les phosphures III (par exemple, le phosphure d'indium gallium (InGaP)).

Une troisième technique, dite « Die To wafer » en anglais, se base sur le transfert de portions de matériau utile, dits « coupons », d'un substrat donneur sur un substrat receveur. Selon cette technique, le substrat donneur est découpé en coupons puis chaque coupon est placé sur la surface du substrat support à l'aide d'un robot. La combinaison de cette technique avec le procédé Smart Cut^{™} permet notamment de déposer une fine couche de matériau sur le substrat receveur.

Cette technique est la plus versatile, notamment en ce que le substrat donneur et le substrat receveur peuvent être de tailles différentes, mais elle est extrêmement lente et induit des coûts de production très élevés.

Il existe également une autre technique, appelée « Micro Transfer printing » en anglais.

Grâce à un tampon en polydiméthylsiloxane (PDMS), un groupe de puces électroniques est prélevé d'un substrat donneur puis transféré sur un substrat receveur. La topologie du tampon permet de ne prélever qu'une sélection de puces à chaque opération, les puces étant réparties selon une distribution conforme au relief du tampon. Plus précisément, le tampon comprend une pluralité de rangées de pavés destinés chacun à recevoir de manière détachable une puce à transférer. Après un premier transfert d'un premier groupe de puces, un second groupe de puces peut être transféré en appliquant le même tampon sur le même substrat donneur, à la différence que le tampon est positionné sur un autre groupe de puces décalé par rapport au premier. Le prélèvement des puces du substrat donneur est effectué par une opération combinant une sous-gravure de puces ou motifs et un détachement mécanique.

Le détachement peut cependant aboutir à une dégradation de la surface du substrat donneur ainsi que des puces électroniques transférées ce qui peut compromettre leur fonctionnement. De plus, cette technique nécessite de sacrifier une quantité importante du substrat donneur, ce qui est problématique dans le cas où celui-ci a une forte valeur. Par ailleurs, les pavés du tampon sont organisés selon un motif fixe déterminé, de sorte que les puces transférées sur le substrat receveur sont nécessairement organisées selon la structure du tampon, ce qui offre très peu de liberté quant au motif à réaliser.

Les documents US 2005/221583 et US2004/238851 décrivent des exemples de ces procédés connus.

### BREVE DESCRIPTION DE L'INVENTION

Un but de l'invention est de proposer un procédé de transfert de pavés d'un substrat donneur sur un substrat receveur permettant de surmonter les inconvénients décrits précédemment.

En particulier, l'invention vise notamment à fournir un tel procédé qui soit compatible avec le transfert de couches minces et avec l'utilisation d'un substrat donneur de forte valeur, et qui permette davantage de liberté concernant les dimensions du substrat donneur et en particulier l'utilisation d'un substrat donneur dont le diamètre est inférieur à celui du substrat receveur.

L'invention a également pour but de permettre le recyclage ainsi que la réutilisation du substrat donneur, ce qui est tout particulièrement intéressant dans le cas d'un substrat donneur à forte valeur.

A cette fin, l'invention propose un procédé de transfert de pavés d'un substrat donneur sur un substrat receveur, comprenant les étapes suivantes :
- disposer un masque en regard d'une surface libre du substrat donneur, le masque présentant une ou plusieurs ouvertures exposant la surface libre du substrat donneur, réparties selon un motif déterminé, de sorte à former au moins une région exposée de la surface libre du substrat donneur, et au moins une région recouverte par le masque,
- former par implantation ionique au travers du masque un plan de fragilisation localisé dans le substrat donneur à l'aplomb d'au moins une région exposée, ledit plan de fragilisation délimitant, dans l'épaisseur du substrat donneur, une région superficielle respective,
- former un pavé en relief par rapport à la surface libre du substrat donneur localisé à l'aplomb de chaque plan de fragilisation respectif, ledit pavé comprenant la région superficielle respective,
- coller le substrat donneur sur le substrat receveur par l'intermédiaire de chaque pavé situé à l'interface de collage, après avoir retiré le masque,
- détacher le substrat donneur le long de chaque plan de fragilisation localisé afin de transférer chaque pavé respectif sur le substrat receveur.

Dans le présent texte, le terme « à l'aplomb » désigne une région située en regard d'une autre dans le sens de l'épaisseur du substrat, c'est-à-dire dans une direction perpendiculaire à la surface principale du substrat. Le terme « localisé à l'aplomb » s'entend d'une région qui est délimitée, dans une direction parallèle à la surface principale du substrat, par l'étendue de l'autre région ; en d'autres termes, une région localisée à l'aplomb d'une autre ne s'étend pas au-delà de cette autre région dans la direction parallèle à la surface principale du substrat.

Ainsi, en particulier, dans le présent procédé, chaque pavé est individualisé dans le substrat donneur en étant délimité, dans une direction parallèle à la surface principale du substrat donneur, par un plan de fragilisation respectif. Ceci permet un transfert localisé de chaque pavé sur le substrat receveur.

Selon d'autres aspects, le procédé proposé présente les différentes caractéristiques suivantes prises seules ou selon leurs combinaisons techniquement possibles :
- selon le procédé :
   - les étapes de disposition du masque, d'implantation ionique, et de formation de chaque pavé sont répétées une ou plusieurs fois sur le même substrat donneur afin de former au moins un deuxième motif décalé par rapport au motif précédent dit premier motif, et
   - les étapes de retrait du masque, de collage, et de détachement sont répétées afin de transférer chaque pavé du substrat donneur sur le même substrat receveur ou un substrat receveur différent ;
- pour former le deuxième motif, le masque est disposé de manière à couvrir l'empreinte de chaque pavé précédemment transféré formée dans l'épaisseur du substrat donneur ;
- selon le procédé :
   - les étapes de disposition du masque, d'implantation ionique, et de formation de chaque pavé sont répétées une ou plusieurs fois sur au moins un deuxième substrat donneur afin de former au moins un deuxième motif, et
   - les étapes de retrait du masque, de collage, et de détachement sont répétées afin de transférer chaque pavé du deuxième substrat donneur sur le même substrat receveur ou sur un substrat receveur différent ;
- la formation de chaque pavé comprend un gonflement du matériau du substrat donneur à partir de la surface libre du substrat donneur sous l'effet de l'implantation ionique ;
- la formation de chaque pavé comprend un dépôt d'une couche additionnelle sur la surface libre du substrat donneur au travers de l'ouverture respective ;
- le dépôt de la couche additionnelle est réalisé après l'implantation ionique, à une température comprise entre 200°C et 250°C ;
- le procédé comprend en outre un traitement de surface visant à rendre la surface exposée des pavés transférés plane et à en réduire la rugosité ;
- le collage des pavés est accompagné d'un recuit thermique du substrat donneur et du substrat receveur ;
- le détachement du substrat donneur est initié thermiquement ou mécaniquement en appliquant un effort mécanique visant à séparer le substrat donneur du substrat receveur ;
- le procédé comprend en outre une étape de recyclage du substrat donneur après transfert des pavés, par traitement de la surface libre dudit substrat donneur visant à la rendre plane et à en réduire la rugosité ;
- le substrat receveur est en silicium et les pavés du substrat donneur sont en matériau semi-conducteur III-V.

### DESCRIPTION DES FIGURES

D'autres avantages et caractéristiques de l'invention apparaîtront à la lecture de la description suivante donnée à titre d'exemple illustratif et non limitatif, en référence aux figures annexées suivantes :
- les figures 1A, 1B, 1C, 1D, 1E, 1F, 1G, 1H, 1I, et 1J illustrent le procédé de transfert de pavés d'un substrat donneur sur un substrat receveur selon un mode de réalisation ;
- les figures 2A, 2B, 2C, 2D, et 2E illustrent la réutilisation du substrat donneur ;
- la figure 3 illustre un premier transfert de pavés d'un substrat donneur sur un substrat receveur, en vue du dessus ;
- la figure 4 illustre un deuxième transfert de pavés en réutilisant le substrat donneur de la figure 3 sur un autre substrat receveur, en vue du dessus ;
- la figure 5 illustre le recyclage du substrat donneur ;
- les figures 6, 7, 8, et 9 illustrent des transferts de pavés agencés selon différents motifs, dans le cas d'un substrat donneur de diamètre inférieur au substrat receveur.

### DESCRIPTION DETAILLEE DE MODES DE REALISATION DE L'INVENTION

L'invention concerne un procédé de transfert de pavés d'un substrat donneur sur un substrat receveur. Ce procédé permet de fabriquer des structures semi-conductrices en transférant un ou plusieurs pavés sur le substrat receveur. De préférence, le substrat receveur est en silicium.

Les pavés se présentent sous la forme d'une pluralité de portions d'une couche mince du substrat donneur, toutes transférées sur le substrat receveur, et sur lesquelles peuvent être fabriqués des composants électroniques, ou encore dans lesquelles des composants électroniques passifs ou actifs sont déjà formés. En effet, la couche mince peut être en un matériau cristallin massif (comme un semi-conducteur) voire une couche contenant une structure fonctionnelle (une couche épitaxiale, un empilement de couches épitaxiales, un dispositif passif ou actif, etc.). Les pavés forment un motif déterminé sur le substrat receveur. Les pavés peuvent être, par exemple, en matériau semi-conducteur III-V.

Outre une portion de ladite couche mince, les pavés peuvent également comprendre une couche supplémentaire, formée par dépôt ou par épitaxie sur ladite portion de couche mince du substrat donneur avant le transfert sur le substrat receveur.

D'une manière générale, le procédé de transfert repose sur le fait que les pavés sont en relief par rapport au reste de la surface du substrat donneur au moment du collage du substrat donneur sur le substrat receveur. Ainsi, l'adhésion entre le substrat donneur et le substrat receveur ne s'effectue qu'au niveau des pavés. On considère qu'un relief de l'ordre de 10 nm est suffisant à cet effet.

Comme cela sera décrit en détail plus bas, il existe différents moyens de créer ce relief. En particulier, ce relief peut être créé en augmentant l'épaisseur de la portion de couche mince du substrat donneur (par gonflement du matériau de ladite couche et/ou par dépôt ou épitaxie localisé(e) d'une couche additionnelle sur chaque portion destinée à former un pavé) et/ou en retirant une zone superficielle du substrat donneur autour des pavés.

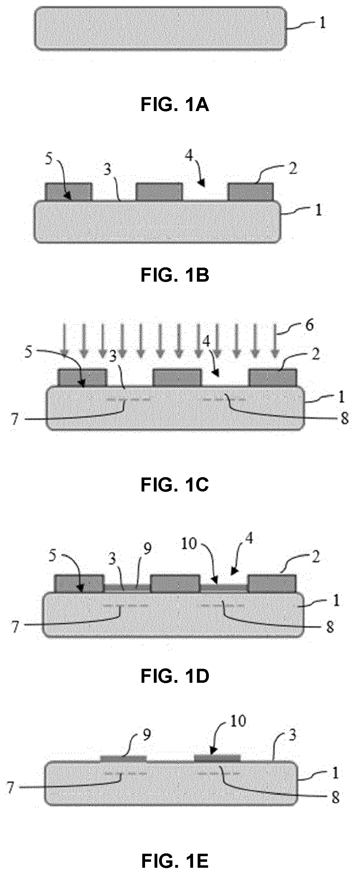

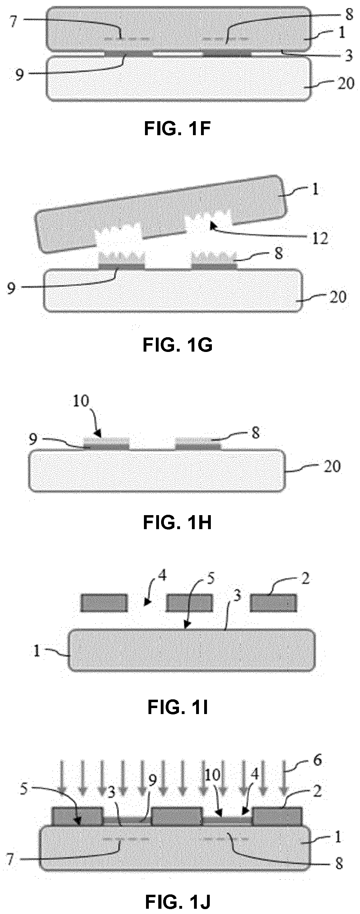

Un mode de réalisation du procédé de transfert est illustré sur les figures 1A à 1J. En référence à la figure 1A, on fournit initialement un substrat 1, dit substrat donneur, dans lequel doivent être réalisés les pavés à transférer. On dispose un masque 2 en regard d'une surface libre 3 du substrat donneur.

Selon un premier mode de réalisation illustré sur la figure 1B, le masque 2 est disposé sur et au contact de la surface libre 3 du substrat donneur, par exemple par dépôt du masque. Le masque 2 peut être une résine ou bien un masque solide, par exemple à base d'oxyde ou de nitrure.

Le masque 2 présente une ou plusieurs ouvertures 4 qui exposent la surface libre 3 du substrat donneur. Les ouvertures 4 sont réparties selon un motif déterminé qui correspond au motif 10 des pavés à former. Cette étape est ainsi désignée en tant que « patterning » en anglais, en référence à la formation du motif.

Sont ainsi formées une ou plusieurs régions 5 recouvertes par le masque, délimitées par les ouvertures 4 correspondant à des régions découvertes au niveau desquelles la surface libre 3 du substrat donneur est exposée.

Cette étape de réalisation du motif peut être réalisée par d'autres moyens que ceux détaillés précédemment, par exemple par lithographie ou par impression.

Alternativement, selon un deuxième mode de réalisation illustré sur la figure 11, le masque 2 est un masque solide et non solidaire du substrat donneur. Le masque est configuré pour former le motif 10 et il peut être, par exemple, un masque d'implantation ionique. Selon ce mode de réalisation, le masque 2 est placé à une distance déterminée de la surface libre 3 du substrat donneur. Ce deuxième mode de réalisation est avantageux dans le cas où l'on cherche à éviter d'interagir avec la surface libre du substrat donneur, afin de ne pas altérer ses propriétés physiques et/ou chimiques. En outre, ce mode de réalisation simplifie le procédé selon l'invention en se passant d'une étape de disposition du masque sur le substrat donneur.

Sur les figures 1C et 1D illustrant les étapes suivantes du procédé, le masque 2 est représenté comme étant positionné sur et au contact de la surface libre du substrat donneur. Ces étapes sont cependant réalisables en positionnant le masque à distance de la surface libre du substrat donneur.

En référence à la figure 1C, on expose ensuite la surface libre 3 du substrat au travers du masque 2 à un faisceau d'espèces ioniques 6.

Les espèces ioniques pénètrent dans le substrat donneur 1 via les ouvertures 4, et s'implantent dans des régions sous-jacentes du substrat donneur, à une profondeur déterminée par les paramètres d'implantation. Les espèces ioniques forment dans le substrat donneur des plans de fragilisation 7 localisés, schématisés sur la figure 1C par des traits en pointillés. Chaque plan de fragilisation 7 est situé en regard d'une ouverture 4 respective du masque, et délimite avec la surface libre 3 dans l'épaisseur du substrat une région superficielle 8.

Les espèces ioniques qui rencontrent le masque 2 sont quant à elles bloquées par ledit masque et ne pénètrent pas dans le substrat donneur 1.

De préférence, les espèces ioniques implantées sont des ions hydrogène et/ou des ions hélium. L'homme du métier est en mesure de déterminer les paramètres d'implantation, notamment la nature des espèces ioniques, la dose et l'énergie des espèces, afin d'implanter les espèces ioniques à la profondeur souhaitée dans le substrat donneur.

Par ailleurs, chaque région superficielle 8 est rehaussée par rapport à la surface libre 3 du substrat donneur, de sorte à former un pavé 9 respectif en relief par rapport à ladite surface 3.

Selon un premier mode de réalisation (non illustré), la formation des pavés 9 est réalisée préalablement à l'implantation ionique, selon une étape distincte. En d'autres termes, on réhausse les régions superficielles 8, puis on fait subir aux régions superficielles 8 réhaussées l'implantation ionique.

Pour ce faire, il est possible par exemple de déposer une couche additionnelle sur la surface libre de chaque région superficielle, au travers d'une ouverture 4 respective du masque. Le dépôt de la couche additionnelle est réalisé à une température adaptée pour ne pas dénaturer le substrat donneur. La température de dépôt de la couche additionnelle dépend également du matériau du substrat donneur et du matériau des pavés à transférer.

Le matériau de la couche additionnelle est choisi de manière à permettre le collage des pavés sur le substrat receveur. Ainsi, le matériau de la couche additionnelle est un matériau de collage, de préférence choisi parmi : SiO₂, Si₃N₄, un métal, ou du silicium amorphe.

Alternativement, il est possible de réaliser une épitaxie à partir de la région superficielle 8 afin de former le pavé.

Selon un deuxième mode de réalisation illustré sur la figure 1D, la formation des pavés 9 est réalisée postérieurement à l'implantation ionique, selon une étape distincte. En d'autres termes, on réhausse les régions superficielles 8 ayant subi préalablement l'implantation ionique.

Pour ce faire, il est possible par exemple de déposer une couche additionnelle sur la surface libre de chaque région superficielle, au travers d'une ouverture 4 respective du masque. Le dépôt de la couche additionnelle est réalisé à une température inférieure à la température de murissement des ions implantés, c'est-à-dire une température inférieure à 250°C, de préférence comprise entre 200°C et 250°C. La température de dépôt de la couche additionnelle dépend également du matériau du substrat donneur et du matériau des pavés à transférer.

Alternativement, il est possible de réaliser une épitaxie à partir de la région superficielle 8 afin de former le pavé.

Dans ces deux modes de réalisation, chaque pavé est constitué de la région superficielle 8 et de la couche additionnelle. Par ailleurs, lorsque le masque est déposé, il est avantageusement choisi en un matériau qui remplit une fonction de masquage vis-à-vis de l'implantation et vis-à-vis du dépôt/épitaxie. Ainsi, un seul masque est suffisant pour la formation des pavés, ce qui minimise le nombre d'étapes du procédé et évite les défauts d'alignement susceptibles d'être rencontrés lors de l'utilisation de plusieurs masques.

Selon un troisième mode de réalisation illustré sur la figure 1J, la formation des pavés 9 est réalisée de manière concomitante à l'implantation ionique. En d'autres termes, chaque pavé en relief est formé par gonflement du matériau du substrat donneur 1 à partir de la surface libre 3 dudit substrat donneur sous l'effet de l'implantation ionique. En effet, il est connu que l'implantation ionique, par exemple du silicium, produit en général un gonflement du matériau et donc une élévation de la surface implantée. Ce gonflement peut atteindre quelques nanomètres voire une dizaine de nanomètres. L'élévation de la surface implantée, dû au gonflement, dépend des conditions d'implantation, notamment de l'espèce implantée, de la dose, et de l'énergie d'implantation.

Selon un quatrième mode de réalisation, il est possible de rehausser les régions superficielles de manière indirecte en gravant non seulement le masque préalablement déposé sur le substrat donneur, mais aussi une région superficielle du substrat donneur, sur une épaisseur correspondant au relief souhaité.

Un premier exemple consiste à disposer un deuxième masque sur le masque disposé préalablement, dit premier masque. Le second masque est complémentaire du premier masque, c'est-à-dire que le deuxième masque recouvre les ouvertures délimitées par le premier masque mais ne recouvre pas les régions recouvertes par le premier masque. On grave ensuite le premier masque au niveau desdites régions recouvertes par le premier masque, ainsi que la région superficielle du substrat donneur. Un deuxième exemple consiste à déposer une couche de matériau sacrificiel dans les ouvertures du masque, puis à graver sélectivement le masque, le matériau sacrificiel protégeant les régions destinées à former les pavés. La gravure est poursuivie jusque dans l'épaisseur du substrat donneur, au niveau des régions précédemment recouvertes par le masque, afin de former des cavités dans l'épaisseur du substrat donneur qui délimitent les couches de matériau sacrificiel. On retire ensuite le matériau sacrificiel pour exposer la surface des pavés, qui est alors en relief par rapport à la surface gravée du substrat donneur.

Tout ou partie des modes de réalisation précédents sont combinables.

Par exemple, il est possible de déposer une couche additionnelle sur la surface libre de chaque région superficielle, puis de réaliser l'implantation ionique au travers de la couche additionnelle pour former les régions superficielles 8, et de réhausser les régions superficielles 8, afin de former les pavés 9 en relief.

Selon un autre exemple, il est possible de réaliser l'implantation ionique pour former de manière concomitante les pavés 9, puis de rehausser encore davantage les pavés 9 après l'implantation ionique.

On obtient, après retrait du masque 2, un substrat donneur 1 muni de pavés 9 en relief par rapport à sa surface libre (native ou issue de gravure le cas échéant), que l'on utilise pour transférer tout ou partie de ces pavés 9 sur un ou plusieurs substrats receveurs 20. Un mode de réalisation de transfert des pavés est illustré sur les figures 1F, 1G, et 1H.

En référence à la figure 1F, on procède au collage du substrat donneur 1 sur le substrat receveur 20.

Le substrat donneur 1 et le substrat receveur 20 sont d'abord positionnés en regard l'un de l'autre. Le collage est réalisé par l'intermédiaire des pavés 9, qui forment l'interface de collage. Plus précisément, le collage ne se fait qu'au niveau des pavés 9. Les régions 6 de la surface libre du substrat donneur 1 précédemment recouvertes par le masque 2 demeurent à distance du substrat receveur 20.

Le substrat donneur 1 est ensuite détaché le long des plans de fragilisation 7, comme l'illustre la figure 1G. Une fracture est initiée puis se propage au niveau des plans de fragilisation, qui sont par nature des zones de plus grande fragilité du substrat. Les pavés 9 du substrat donneur 1 sont ainsi transférés sur le substrat receveur 20. La fracture peut se déclencher spontanément en chauffant l'assemblage des substrats à une température donnée, et/ou être déclenchée en appliquant au substrat donneur une contrainte mécanique.

Etant donné que le substrat donneur 1 est fracturé au niveau des plans de fragilisation 7, la surface libre 3 des régions superficielles 8 des pavés 9, qui est opposée au substrat receveur 20 par rapport au pavé 9, présente généralement une rugosité élevée. On effectue donc de préférence un traitement de ladite surface libre de chaque région superficielle transférée afin de la lisser et d'en réduire la rugosité, par exemple par polissage mécano-chimique (CMP) ou traitement chimique et/ou thermique.

Le substrat receveur 20 obtenu est représenté sur la figure 1H. Il comprend les pavés 9 comprenant les régions superficielles 8 dont la surface libre 3 a de préférence été traitée.

Le procédé de l'invention permet de transférer tous les pavés 9 constitutifs du motif 10 du substrat donneur 1 sur le substrat receveur 20 en une seule itération du procédé, à l'issue de l'étape de collage et de l'étape de détachement, ce qui réduit les temps de production et donc les coûts de production des structures de type semi-conducteur ainsi fabriquées par rapport aux procédés connus.

Un avantage du procédé de l'invention réside dans la possibilité d'utiliser plusieurs fois le même substrat donneur, sans qu'il ne soit nécessaire de le recycler.

La réutilisation et le recyclage du substrat donneur sont deux aspects différents, qui vont maintenant être décrits ci-après.

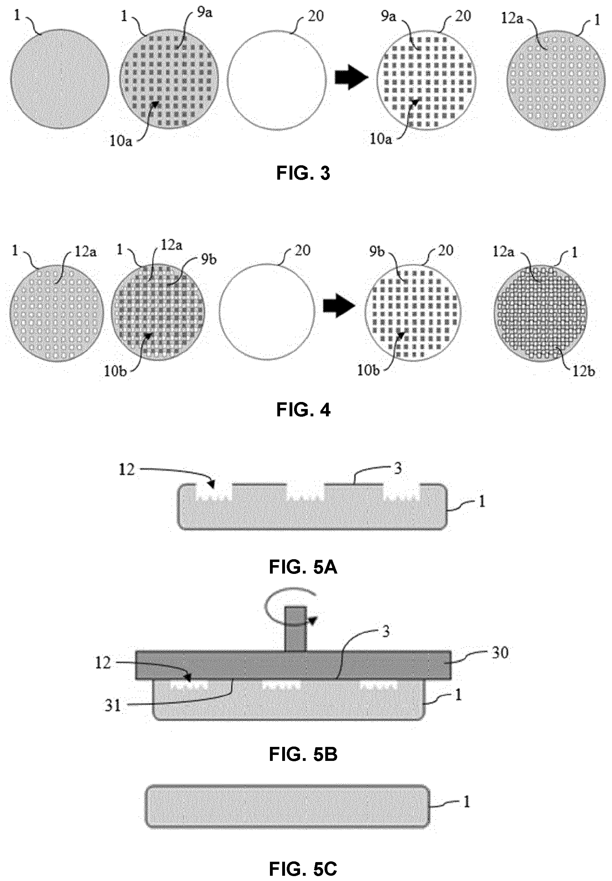

La réutilisation du substrat donneur 1 consiste en une ou plusieurs itérations supplémentaires des étapes décrites précédemment. En d'autres termes, les étapes de disposition du masque 2 et de formation de chaque pavé sont répétées une ou plusieurs fois sur le même substrat donneur, dans des régions du substrat donneur qui n'ont pas été utilisées lors de la première itération du procédé, afin de former au moins un deuxième motif 10b décalé par rapport au motif précédent dit premier motif 10a (cf. figures 3 et 4). Les étapes de retrait du masque 2, de collage, et de détachement sont également répétées afin de transférer chaque pavé 9a du substrat donneur 1 sur le même substrat receveur 20 ou sur un substrat receveur différent.

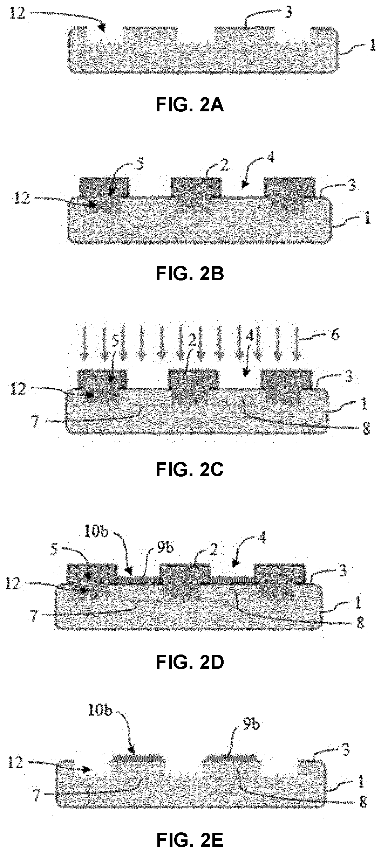

Un mode de réalisation illustrant la réutilisation du substrat donneur 1 obtenu après son détachement du substrat receveur 20 sur la figure 1G est schématisé sur les figures 2A à 2E.

Le substrat donneur 1 à réutiliser est illustré sur la figure 2A. On dispose le masque 2 en regard de la surface libre 3 du substrat donneur.

Le masque 2 présente une ou plusieurs ouvertures 4 qui exposent la surface libre du substrat donneur. Les ouvertures 4 sont réparties selon un deuxième motif 10b déterminé qui correspond au motif des pavés formé ultérieurement sur ledit substrat donneur. Ce deuxième motif 10b est décalé dans le plan de la surface libre 3 du substrat donneur par rapport au premier motif 10a réalisé précédemment lors de la première itération du procédé.

La disposition du masque 2 peut être réalisée conformément au premier mode de réalisation décrit précédemment selon lequel le masque est disposé sur et au contact de la surface libre 3 du substrat donneur, ou selon le deuxième mode de réalisation décrit précédemment selon lequel le masque est disposé à une distance déterminée de la surface libre du substrat donneur.

Quel que soit le mode de réalisation de disposition du masque, le masque 2 est préférentiellement disposé de manière à couvrir l'empreinte 12 de chaque pavé 9b précédemment transféré formée dans l'épaisseur du substrat donneur 1, comme l'illustre la figure 2B.

En référence à la figure 2C, on expose ensuite la surface libre 3 du substrat donneur sur laquelle a été déposé le masque 2 au faisceau d'espèces ioniques. On forme ainsi des plans de fragilisation 7 dans le substrat donneur, schématisés sur la figure 2C par des traits en pointillés. Chaque plan de fragilisation 7 est situé en regard d'une ouverture 4 respective du masque et délimite, avec la surface libre du substrat, une région superficielle 8.

Chaque région superficielle 8 est rehaussée par rapport à la surface libre 3 du substrat donneur, de sorte à former un ou plusieurs pavés 9b en relief par rapport à ladite surface 3 arrangés selon un deuxième motif 10b.

Le rehaussement est réalisé de manière analogue au premier motif, avantageusement selon un mode de réalisation ou une combinaison des modes de réalisation décrits précédemment.

A l'issue de la formation des pavés 9b, on obtient alors le substrat donneur 1 illustré sur la figure 2D, comprenant les régions couvertes 5 par le masque et le deuxième motif de pavés 10b.

Après retrait du masque 2, le substrat donneur 1 illustré sur la figure 2E est utilisé pour transférer le deuxième motif de pavés 10b sur le même substrat receveur 20 que précédemment lors de la première itération du procédé, ou sur un substrat receveur différent.

Les figures 3 et 4 illustrent la réutilisation d'un même substrat donneur, pour transférer plusieurs motifs de pavés sur des substrats receveurs différents.

En référence à la figure 3, on forme un premier motif de pavés 10a sur le substrat donneur 1, puis on transfère ledit motif de pavés 10a sur le substrat receveur 20 par collage des pavés 9a sur la surface libre 3 du substrat receveur 20 puis détachement du substrat donneur. On obtient le substrat receveur 20 muni du motif de pavés transférés 9a, ainsi que le substrat donneur 1 dans l'épaisseur duquel s'étendent les empreintes 12a des pavés transférés 9a, depuis la surface libre dudit substrat donneur.

En référence à la figure 4, et uniquement à titre d'exemple, on réutilise le même substrat donneur 1 que l'on fait pivoter de 180° par rapport à un axe perpendiculaire à la surface libre du substrat, et dans lequel on forme un deuxième motif 10b de pavés. Le deuxième motif de pavés 10b est décalé selon le plan de la surface libre 3 du substrat, par rapport au premier motif 10a et formé de manière analogue au premier motif. On transfère le deuxième motif de pavés 10b sur un substrat receveur 20 différent du précédent, par collage des pavés 9b sur la surface libre du substrat receveur puis détachement du substrat donneur. On obtient le substrat receveur 20 muni du deuxième motif de pavés 10b transférés, ainsi que le substrat donneur 1 dans l'épaisseur duquel s'étendent les empreintes 12b du premier motif de pavés 10a et du deuxième motif de pavés 10b transférés, depuis la surface libre dudit substrat donneur.

Le mode de réalisation de la figure 4 illustre la possibilité de réutiliser plusieurs fois le même substrat donneur pour plusieurs transferts successifs, sans avoir besoin de le recycler.

Selon un autre mode de réalisation, le motif 10b peut être transféré sur le substrat receveur 20 comportant préalablement le motif 10a ou un autre motif n'interférant pas avec le motif 10b.

Le recyclage du substrat donneur 1 consiste à traiter sa surface libre 3 ayant préalablement servi au transfert d'un motif de pavés, afin de supprimer les régions endommagées qui comprenaient les pavés 9 avant leur transfert sur le substrat receveur 20. La surface libre du substrat donneur est rendue substantiellement plane et présente une rugosité réduite par rapport à son état avant recyclage. On recrée ainsi un état de surface du substrat donneur comparable à ce qu'il était avant son utilisation dans le procédé de transfert de l'invention.

Le recyclage permet d'utiliser au maximum l'ensemble du substrat donneur en limitant les pertes, ce qui est tout particulièrement avantageux lorsque le substrat donneur a une forte valeur, par exemple lorsqu'il est fabriqué dans un matériau semi-conducteur III-V.

Le recyclage est possible et avantageux puisque l'implantation ionique et le détachement ne consomment qu'une faible couche de matière dans l'épaisseur du substrat.

Un traitement de surface qui convient pour le recyclage du substrat donneur est la planarisation mécano-chimique, dite Chemical Mechanical Polishing/Planarization en anglais (acronyme CMP).

Un mode de réalisation illustrant le recyclage du substrat donneur obtenu après son détachement du substrat receveur sur la figure 1G, est schématisé sur les figures 5A, 5B, et 5C.

Le substrat donneur 1 à recycler est illustré sur la figure 5A. En référence à la figure 5B, on vient ensuite appliquer une surface plane 31 d'un appareil de lissage 30 au contact de la surface libre 3 endommagée du substrat donneur, puis on entraine en rotation l'appareil selon un axe perpendiculaire au plan du substrat, afin de lisser ladite surface libre. Le substrat donneur 1 obtenu après lissage est représenté sur la figure 5C.

Bien évidemment, le recyclage et la réutilisation sont combinables, pour la réalisation de plusieurs itérations du procédé de transfert selon l'invention. Par exemple, le substrat donneur peut être recyclé après plusieurs réutilisations pour le transfert de plusieurs motifs de pavés. Ledit substrat peut ensuite être réutilisé pour une ou plusieurs autres itérations du procédé, puis de nouveau recyclé.

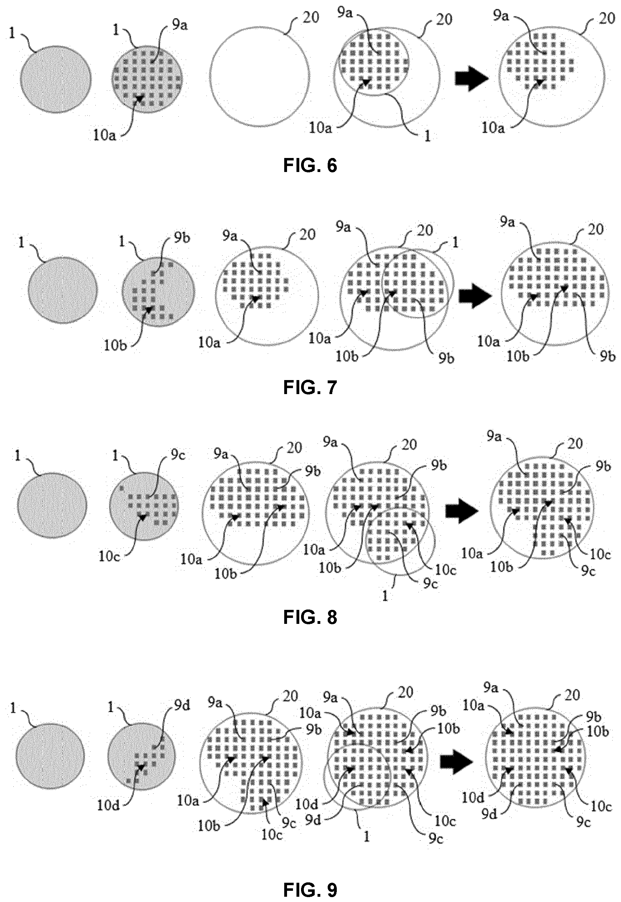

Les figures 6 à 9 illustrent le transfert de pavés en plusieurs itérations du procédé de transfert selon l'invention. On transfère quatre motifs distincts 10a, 10b, 10c, 10d, en utilisant un substrat donneur différent pour chaque transfert, sur un même substrat receveur. Les substrats donneurs 1a, 1b, 1c, 1d ont tous sensiblement le même diamètre, celui-ci étant inférieur au diamètre du substrat receveur 20.

Le fait que le diamètre des substrats donneurs soit inférieur à celui du substrat receveur, permet de transférer l'ensemble des pavés de chaque substrat donneur, en un seul transfert, sur une région déterminée de la surface libre du substrat receveur. Il devient donc possible de construire un motif de pavés final par assemblage d'une pluralité de motifs de pavés transférés par plusieurs itérations successives du procédé de l'invention.

Selon un autre mode de réalisation, le procédé permet également de transférer des pavés provenant de différents substrats de sorte à transférer sur le substrat receveur des pavés de différentes natures ou de différentes fonctionnalités.

En référence à la figure 6, on forme un premier motif de pavés 10a sur un premier substrat donneur 1a, puis on transfère ledit motif de pavés sur une première région déterminée de la surface libre du substrat receveur. Lors du collage, le substrat donneur 1a est positionné en regard du substrat receveur 20 de sorte que l'ensemble des pavés 9a viennent au contact de la surface libre 3 du substrat receveur et soient transférés sur ledit substrat receveur. Sur la figure 6, le substrat donneur 1a dépasse très légèrement hors de la périphérie du substrat receveur 20.

A l'issue du transfert, la surface libre du substrat receveur est partiellement recouverte, dans une première région, du premier motif de pavés transféré 10a.

En référence à la figure 7, on forme un deuxième motif de pavés 10b sur un deuxième substrat donneur 1b, puis on transfère ce deuxième motif de pavés 10b sur une deuxième région déterminée de la surface libre du même substrat receveur 20. Le deuxième motif 10b transféré sur le substrat receveur complète le premier motif 10a, de sorte que les lignes et les colonnes de pavés 9a du deuxième motif 10a complètent au moins en partie les lignes et les colonnes respectivement du premier motif 10b. Sur la figure 7, le substrat donneur 1b dépasse légèrement hors de la périphérie du substrat receveur 20.

En référence à la figure 8, on forme un troisième motif de pavés 10c sur un troisième substrat donneur 1c, puis on transfère ce troisième motif de pavés 10c sur une troisième région déterminée de la surface libre du même substrat receveur 20. Le troisième motif 10c transféré sur le substrat receveur complète le premier motif 10a et le deuxième motif 10b, de sorte que les lignes et les colonnes de pavés du troisième motif 10c complètent au moins en partie les lignes et les colonnes respectivement du premier motif 10a et du deuxième motif 10b. Sur la figure 8, le substrat donneur 1c dépasse hors de la périphérie du substrat receveur 20.

En référence à la figure 9, on forme un quatrième motif de pavés 10d sur un quatrième substrat donneur 1d, puis on transfère ce quatrième motif de pavés 10d sur une quatrième région déterminée de la surface libre du même substrat receveur 20. Le quatrième motif 10d transféré sur le substrat receveur complète le premier motif 10a, le deuxième motif 10b, et le troisième motif 10c de sorte que les lignes et les colonnes de pavés 9d du quatrième motif 10d complètent au moins en partie les lignes et les colonnes respectivement du premier motif 10a, du deuxième motif 10b, et du troisième motif 10c. Sur la figure 9, le substrat donneur 1d dépasse hors de la périphérie du substrat receveur 20.

A l'issue des quatre étapes de transfert, on a formé un motif de pavés final 11 sur le substrat receveur 20, composé des quatre motifs de pavés 10a, 10b, 10c, 10d transférés successivement.

## Revendications

1. Procédé de transfert de pavés (9) d'un substrat donneur (1) sur un substrat receveur (20), comprenant les étapes suivantes :
- disposer un masque (2) en regard d'une surface libre (3) du substrat donneur, le masque (2) présentant une ou plusieurs ouvertures (4) exposant la surface libre (3) du substrat donneur, réparties selon un motif (10) déterminé, de sorte à former au moins une région exposée de la surface libre du substrat donneur, et au moins une région recouverte (5) par le masque,
- former par implantation ionique au travers du masque (2) un plan de fragilisation (7) localisé dans le substrat donneur (1) à l'aplomb d'au moins une région exposée, ledit plan de fragilisation (7) délimitant, dans l'épaisseur du substrat donneur, une région superficielle (8) respective,
- former un pavé (9) en relief par rapport à la surface libre (3) du substrat donneur localisé à l'aplomb de chaque plan de fragilisation (7) respectif, ledit pavé comprenant la région superficielle (8) respective,
- coller le substrat donneur (1) sur le substrat receveur (20) par l'intermédiaire de chaque pavé (9) situé à l'interface de collage, après avoir retiré le masque (2),
- détacher le substrat donneur (1) le long de chaque plan de fragilisation (7) localisé afin de transférer chaque pavé (9) respectif sur le substrat receveur (20).

2. Procédé selon la revendication 1, dans lequel :
- les étapes de disposition du masque (2), d'implantation ionique, et de formation de chaque pavé (9) sont répétées une ou plusieurs fois sur le même substrat donneur (1) afin de former au moins un deuxième motif (10b) décalé par rapport au motif précédent (10a) dit premier motif, et
- les étapes de retrait du masque (2), de collage, et de détachement sont répétées afin de transférer chaque pavé (9) du substrat donneur (1) sur le même substrat receveur (20) ou un substrat receveur différent.

3. Procédé selon la revendication 2, dans lequel pour former le deuxième motif (10b), le masque (2) est disposé de manière à couvrir l'empreinte (12) de chaque pavé (9) précédemment transféré formée dans l'épaisseur du substrat donneur (1).

4. Procédé selon la revendication 1, dans lequel :
- les étapes de disposition du masque (2), d'implantation ionique, et de formation de chaque pavé (9) sont répétées une ou plusieurs fois sur au moins un deuxième substrat donneur afin de former au moins un deuxième motif (10b), et
- les étapes de retrait du masque (2), de collage, et de détachement sont répétées afin de transférer chaque pavé (9) du deuxième substrat donneur sur le même substrat receveur (20) ou sur un substrat receveur différent.

5. Procédé selon l'une quelconque des revendications précédentes, dans lequel la formation de chaque pavé (9) comprend un gonflement du matériau du substrat donneur (1) à partir de la surface libre (3) du substrat donneur sous l'effet de l'implantation ionique.

6. Procédé selon l'une quelconque des revendications 1 à 4, dans lequel la formation de chaque pavé (9) comprend un dépôt d'une couche additionnelle sur la surface libre du substrat donneur au travers de l'ouverture respective.

7. Procédé selon la revendication 6, dans lequel le dépôt de la couche additionnelle est réalisé après l'implantation ionique, à une température comprise entre 200°C et 250°C.

8. Procédé selon l'une quelconque des revendications précédentes, comprenant en outre un traitement de surface visant à rendre la surface exposée des pavés transférés plane et à en réduire la rugosité.

9. Procédé selon l'une des revendications précédentes, dans lequel le collage des pavés (9) est accompagné d'un recuit thermique du substrat donneur (1) et du substrat receveur (20).

10. Procédé selon l'une quelconque des revendications précédentes, dans lequel le détachement du substrat donneur (1) est initié thermiquement ou mécaniquement en appliquant un effort mécanique visant à séparer le substrat donneur (1) du substrat receveur (20).

11. Procédé selon l'une quelconque des revendications précédentes, comprenant en outre une étape de recyclage du substrat donneur (1) après transfert des pavés (9), par traitement de la surface libre dudit substrat donneur (1) visant à la rendre plane et à en réduire la rugosité.

12. Procédé selon l'une quelconque des revendications précédentes, dans lequel le substrat receveur (20) est en silicium et les pavés du substrat donneur (1) sont en matériau semi-conducteur III-V.

## Patentansprüche

1. Verfahren zur Übertragung von Blöcken (9) von einem Donatorsubstrat (1) auf ein Empfängersubstrat (20), die folgenden Schritte umfassend:
- Anordnen einer Maske (2) gegenüber einer freien Oberfläche (3) des Donatorsubstrats, wobei die Maske (2) eine oder mehrere Öffnungen (4) aufweist, die die freie Oberfläche (3) des Donatorsubstrats freilegen, die nach einem bestimmten Muster (10) verteilt sind, so dass mindestens ein freigelegter Bereich der freien Oberfläche des Donatorsubstrats gebildet wird und mindestens ein von der Maske bedeckter Bereich (5),
- Bilden, durch Ionenimplantation durch die Maske (2) hindurch, einer Versprödungsebene (7), die im Donatorsubstrat (1) lotrecht zu mindestens einem freigelegten Bereich lokalisiert ist, wobei die Versprödungsebene (7) in der Dicke des Donatorsubstrats einen jeweiligen Oberflächenbereich (8) eingrenzt,
- Bilden eines Blocks (9), hervorgehoben in Bezug auf die freie Oberfläche (3) des Donatorsubstrats, lotrecht zu jeder jeweiligen Versprödungsebene (7) lokalisiert, wobei der Block den jeweiligen Oberflächenbereich (8) umfasst,
- Verkleben des Donatorsubstrats (1) auf das Empfängersubstrat (20) mittels jedem Block (9), der sich an der Verklebungsschnittstelle befindet, nachdem die Maske (2) entfernt wurde,
- Ablösen des Donatorsubstrats (1) entlang jeder lokalisierten Versprödungsebene (7), um jeden jeweiligen Block (9) auf das Empfängersubstrat (20) zu übertragen.

2. Verfahren nach Anspruch 1, wobei:
- die Schritte der Anordnung der Maske (2), der Ionenimplantation und der Bildung jedes Blocks (9) ein-oder mehrmals auf demselben Donatorsubstrat (1) wiederholt werden, um mindestens ein zweites Muster (10b) zu bilden, das in Bezug auf das vorhergehende Muster (10a), erstes Muster genannt, versetzt ist, und
- die Schritte der Entfernung der Maske (2), der Verklebung und der Ablösung wiederholt werden, um jeden Block (9) des Donatorsubstrats (1) auf dasselbe Empfängersubstrat (20) oder ein anderes Empfängersubstrat zu übertragen.

3. Verfahren nach Anspruch 2, wobei, zur Bildung des zweiten Musters (10b), die Maske (2) so angeordnet ist, dass sie die Vertiefung (12) jedes zuvor übertragenen Blocks (9) abdeckt, die in der Dicke des Donatorsubstrats (1) gebildet wurde.

4. Verfahren nach Anspruch 1, wobei:
- die Schritte der Anordnung der Maske (2), der Ionenimplantation und der Bildung jedes Blocks (9) ein-oder mehrmals auf mindestens einem zweiten Donatorsubstrat wiederholt werden, um mindestens ein zweites Muster (10b) zu bilden, und
- die Schritte der Entfernung der Maske (2), der Verklebung und der Ablösung wiederholt werden, um jeden Block (9) des zweiten Donatorsubstrats auf dasselbe Empfängersubstrat (20) oder auf ein anderes Empfängersubstrat zu übertragen.

5. Verfahren nach einem der vorhergehenden Ansprüche, wobei die Bildung jedes Blocks (9) eine Quellung des Donatorsubstratmaterials (1) ausgehend von der freien Oberfläche (3) des Donatorsubstrats umfasst, unter Einwirkung der Ionenimplantation.

6. Verfahren nach einem der Ansprüche 1 bis 4, wobei die Bildung jedes Blocks (9) eine Abscheidung einer zusätzlichen Schicht auf der freien Oberfläche des Donatorsubstrats durch die jeweilige Öffnung hindurch umfasst.

7. Verfahren nach Anspruch 6, wobei die Abscheidung der zusätzlichen Schicht nach der Ionenimplantation bei einer Temperatur zwischen 200 °C und 250 °C erfolgt.

8. Verfahren nach einem der vorhergehenden Ansprüche, ferner eine Oberflächenbehandlung umfassend, die darauf abzielt, die freigelegte Oberfläche der übertragenen Blöcke eben zu machen und ihre Rauheit zu verringern.

9. Verfahren nach einem der vorhergehenden Ansprüche, wobei der Verklebung der Blöcke (9) von einem thermischen Tempern des Donatorsubstrats (1) und des Empfängersubstrats (20) begleitet wird.

10. Verfahren nach einem der vorhergehenden Ansprüche, wobei die Ablösung des Donatorsubstrats (1) thermisch oder mechanisch eingeleitet wird durch eine mechanische Belastung, die darauf abzielt, das Donatorsubstrat (1) vom Empfängersubstrat (20) zu trennen.

11. Verfahren nach einem der vorhergehenden Ansprüche, ferner einen Schritt der Wiederverwendung des Donatorsubstrats (1) nach der Übertragung der Blöcke (9) umfassend, durch Behandlung der freien Oberfläche des Donatorsubstrats (1), die darauf abzielt, sie eben zu machen und ihre Rauheit zu verringern.

12. Verfahren nach einem der vorhergehenden Ansprüche, wobei das Empfängersubstrat (20) aus Silizium besteht und die Blöcke des Donatorsubstrats (1) aus III-V-Halbleitermaterial bestehen.

## Claims

1. Process for transferring blocks (9) from a donor substrate (1) to a receiver substrate (20), comprising the following steps:
- arranging a mask (2) facing a free surface (3) of the donor substrate, the mask (2) having one or more openings (4) that expose the free surface (3) of the donor substrate, these being distributed according to a given pattern (10), so as to form at least one exposed region of the free surface of the donor substrate, and at least one region (5) covered by the mask,
- forming, by ion implantation through the mask (2), an embrittlement plane (7) localized in the donor substrate (1) vertically in line with at least one exposed region, said embrittlement plane (7) delimiting, in the thickness of the donor substrate, a respective surface region (8),
- forming a block (9) that is raised relative to the free surface (3) of the donor substrate localized vertically in line with each respective embrittlement plane (7), said block comprising the respective surface region (8),
- bonding the donor substrate (1) to the receiver substrate (20) via each block (9) located at the bonding interface, after having removed the mask (2),
- detaching the donor substrate (1) along each localized embrittlement plane (7) in order to transfer each respective block (9) to the receiver substrate (20).

2. Process according to Claim 1, wherein:
- the steps of arranging the mask (2), of ion implantation, and of forming each block (9) are repeated one or more times on the same donor substrate (1) in order to form at least a second pattern (10b) that is offset relative to the preceding pattern (10a), referred to as the first pattern, and
- the steps of removing the mask (2), of bonding, and of detaching are repeated in order to transfer each block (9) from the donor substrate (1) to the same receiver substrate (20) or a different receiver substrate.

3. Process according to Claim 2, wherein to form the second pattern (10b), the mask (2) is arranged so as to cover the recess (12) left in the thickness of the donor substrate (1) by each previously transferred block (9).

4. Process according to Claim 1, wherein:
- the steps of arranging the mask (2), of ion implantation, and of forming each block (9) are repeated one or more times on at least a second donor substrate in order to form at least a second pattern (10b), and
- the steps of removing the mask (2), of bonding, and of detaching are repeated in order to transfer each block (9) from the second donor substrate to the same receiver substrate (20) or to a different receiver substrate.

5. Method according to any one of the preceding claims, wherein the operation of forming each block (9) comprises a swelling of the material of the donor substrate (1) from the free surface (3) of the donor substrate under the effect of ion implantation.

6. Method according to any one of Claims 1 to 4, wherein the operation of forming each block (9) comprises an operation of depositing an additional layer on the free surface of the donor substrate through the respective opening.

7. Process according to Claim 6, wherein the operation of depositing the additional layer is performed after ion implantation, at a temperature between 200°C and 250°C.

8. Process according to any one of the preceding claims, further comprising a surface treatment that aims to make the exposed surface of the transferred blocks planar and to decrease the roughness thereof.

9. Process according to one of the preceding claims, wherein the operation of bonding the blocks (9) is accompanied by an operation of thermally annealing the donor substrate (1) and the receiver substrate (20).

10. Process according to any one of the preceding claims, wherein the operation of detaching the donor substrate (1) is initiated thermally or mechanically by applying a mechanical stress with a view to separating the donor substrate (1) from the receiver substrate (20).

11. Process according to any one of the preceding claims, further comprising a step of recycling the donor substrate (1) after transferring the blocks (9) by treating the free surface of said donor substrate (1) in order to make it planar and decrease the roughness thereof.

12. Process according to any one of the preceding claims, wherein the receiver substrate (20) is made of silicon and the blocks of the donor substrate (1) are made of III-V semiconductor material.
